(19) Europäisches Patentamt
European Patent Office
Office européen des brevets

(11) **EP 3 163 622 B1**

(12) **FASCICULE DE BREVET EUROPEEN**

(45) Date de publication et mention
de la délivrance du brevet:
**02.05.2018 Bulletin 2018/18**

(51) Int Cl.:
**H01L 27/144** *(2006.01)*    **G02F 3/02** *(2006.01)*

(21) Numéro de dépôt: **16196119.8**

(22) Date de dépôt: **27.10.2016**

(54) **CELLULE LOGIQUE PHOTOSENSIBLE A ILLUMINATION PAR LA FACE AVANT**

LICHTEMPFINDLICHE LOGIKZELLE ZUR BELEUCHTUNG VON DER VORDERSEITE

PHOTOSENSITIVE LOGIC CELL FOR ILLUMINATION FROM THE FRONT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.10.2015 FR 1560288**

(43) Date de publication de la demande:
**03.05.2017 Bulletin 2017/18**

(73) Titulaire: **COMMISSARIAT À L'ÉNERGIE
ATOMIQUE ET AUX
ÉNERGIES ALTERNATIVES
75015 Paris (FR)**

(72) Inventeurs:
• **ROZEAU, Olivier
38430 MOIRANS (FR)**
• **GRENOUILLET, Laurent
38640 CLAIX (FR)**

(74) Mandataire: **Brevalex
95, rue d'Amsterdam
75378 Paris Cedex 8 (FR)**

(56) Documents cités:
**EP-A1- 2 587 539    US-A1- 2004 201 047
US-A1- 2006 125 038**

• **TSUCHIYA R ET AL: "Silicon on thin BOX: a new
paradigm of the CMOSFET for low-power and
high-performance application featuring
wide-range back-bias control", ELECTRON
DEVICES MEETING, 2004. IEDM TECHNICAL
DIGEST. IEEE INTERNATIO NAL SAN
FRANCISCO, CA, USA DEC. 13-15, 2004,
PISCATAWAY, NJ, USA,IEEE, 13 décembre 2004
(2004-12-13), pages 631-634, XP010788872, DOI:
10.1109/IEDM.2004.1419245 ISBN:
978-0-7803-8684-6**

**Description**

**DOMAINE TECHNIQUE ET ART ANTÉRIEUR**

La présente invention se rapporte au domaine des dispositifs photosensibles et concerne la mise en oeuvre d'une cellule logique photosensible encore appelée inverseur logique photonique, à illumination par la face avant.

Dans le domaine technique des dispositifs photosensibles, le document EP 2 587 539 présente un dispositif microélectronique formé d'un transistor réalisé en face avant d'un substrat de type semi-conducteur sur isolant dont la tension de seuil peut être modulée en fonction d'une quantité de photons reçue par une zone photosensible située dans la couche de support semi-conductrice du substrat et séparée de la zone de canal du transistor par le biais de la couche isolante du substrat. La variation de tension de seuil du transistor est permise grâce à l'établissement d'un couplage capacitif entre la zone photosensible et la zone de canal du transistor. Ainsi, lorsqu'il n'y a pas de rayonnement lumineux à détecter, la tension de seuil du transistor est égale à une valeur $Vt_1$, tandis que lorsqu'il y a un rayonnement lumineux à détecter, la tension de seuil du transistor est égale à une valeur $Vt_2$ différente de $Vt_1$. A l'aide d'un tel dispositif, on peut chercher à mettre en oeuvre un mode de détection binaire de rayonnement lumineux.

L'illumination du dispositif est réalisée principalement par la face arrière c'est à dire la face opposée à la face avant sur laquelle le transistor est réalisé.

Pour améliorer la collection de photons par la zone photosensible on cherche généralement à réduire l'épaisseur de la couche de support, ce qui peut rendre le substrat fragile.

Il se pose le problème de réaliser un nouveau dispositif photosensible susceptible de réaliser une détection de rayonnement lumineux et de pouvoir traduire cette détection sous forme d'un signal numérique et qui est en outre amélioré vis-à-vis d'inconvénients énoncés ci-dessus.

**EXPOSÉ DE L'INVENTION**

La présente invention concerne une cellule logique photosensible selon la revendication 1. Ainsi, la cellule est configurée en regard de la région de photo-détection de la zone photosensible de manière à favoriser l'absorption de photons par la face avant c'est-à-dire la face sur laquelle les transistors sont disposés.

Avantageusement un moyen d'isolation électrique pour isoler la cellule d'au moins un autre élément juxtaposé est prévu et comprend une électrode de grille supplémentaire disposée en périphérie de la cellule.

Cette grille supplémentaire s'étend autour d'une région de la cellule où une première grille et une deuxième électrode de grille sont disposées.

Un tel moyen d'isolation est peu encombrant, ce qui peut permettre de prévoir en contrepartie et si nécessaire une région de photo-détection de taille importante et d'obtenir ainsi une cellule de sensibilité améliorée.

La grille supplémentaire permet également de réaliser une isolation électrique sans devoir former de zone isolante entre ladite cellule un autre élément juxtaposé, par exemple une autre cellule ou un circuit.

Avec une telle isolation, on garde intacte la couche de support et la couche superficielle, ce qui permet d'éviter la création de défaut dans ces couches et de limiter ainsi les courants de fuite.

L'électrode de grille supplémentaire peut réaliser un contour fermé autour des grilles du premier et du deuxième transistor.

Selon une possibilité de mise en oeuvre, le premier et le deuxième transistor comportent respectivement une première grille et une deuxième grille disposées en regard d'une autre région de la zone photosensible, cette autre région étant située en périphérie de la région de photo-détection. La couche isolante du substrat s'étend en regard de l'ouverture et de la région de photo-détection. La couche isolante peut permettre de limiter les effets de recombinaison de surface. Cela permet d'améliorer la sensibilité de la cellule.

On peut avantageusement doter la cellule d'un transistor d'évacuation de charges connecté à la zone photosensible. Cela peut permettre une décharge plus rapide de la zone photosensible et de pouvoir réduire l'intervalle de temps entre deux cycles de lecture d'un état logique de la cellule

Un tel transistor d'évacuation de charges peut être prévu pour permettre, en fonction de son état de polarisation, de pouvoir décharger une région de la zone photosensible située sous la couche isolante.

Selon une possibilité de mise en oeuvre, ce transistor d'évacuation de charges et la zone photosensible sont connectés par le biais d'au moins un élément de connexion en contact avec la région de photo-détection et passant dans ladite ouverture.

Un circuit de commande de polarisation configuré pour appliquer un signal au transistor d'évacuation de charges est alors prévu. L'état de ce signal est modifié en fonction de l'état de fonctionnement dans lequel on souhaite placer la cellule.

Ce signal émis par le circuit de commande peut être appliqué sur la grille du transistor d'évacuation de charges de sorte à bloquer le transistor d'évacuation de charges lorsqu'une lecture d'un état logique en sortie de la cellule est effectuée, et de sorte à rendre passant le transistor d'évacuation de charges lorsqu'un effacement de l'état logique en sortie de la cellule est effectué.

Le premier transistor et le deuxième transistor peuvent être agencés de sorte à avoir leurs grilles connectées entre elles et leurs drains connectés entre eux.

La cellule logique photosensible peut être agencée de sorte à former un inverseur logique photosensible.

Avantageusement, les transistors de la cellule sont réalisés dans une technologie FDSOI pour « Fully Depleted Silicon On Insulator ».

La cellule logique photosensible peut être intégrée à un dispositif matriciel doté d'une matrice de cellules logiques photosensibles.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1A sert à illustrer un exemple de structure de cellule logique photosensible mise en oeuvre sur un substrat de type semi-conducteur sur isolant et comportant un premier transistor et un deuxième transistor de type différents disposés en face avant du substrat et en regard d'une zone photosensible, cette zone photosensible comprenant une région de photo-détection en regard de laquelle la couche semi-conductrice superficielle du substrat ne s'étend pas afin de favoriser l'absorption de photons par la face avant ;
- la figure 1B illustre un premier exemple de configuration de d'inverseur logique photosensible formé à partir de la cellule de la figure 1A, l'état logique de la sortie de l'inverseur dépendant d'une quantité de photons reçue par celui-ci,
- les figures 1C-1D illustrent des caractéristiques électriques de fonctionnement de l'inverseur de la figure 1B ;
- les figures 2A-2B illustrent un deuxième exemple de configuration de d'inverseur logique photosensible,
- les figures 2C-2D illustrent des caractéristiques électriques de fonctionnement du deuxième exemple d'inverseur ;
- la figure 3 illustre la variante de réalisation selon l'invention pour laquelle la couche semi-conductrice superficielle du substrat est retirée en regard de la région de photo-détection tandis que la couche isolante du substrat est conservée ;
- les figures 4A-4D illustrent différentes variantes d'agencements d'électrodes de grille des transistors de la cellule photosensible ;
- les figures 5A-5B illustrent un premier exemple de cellule logique photosensible muni d'un transistor d'évacuation de charges ;
- les figures 6A-6B illustrent un deuxième exemple de cellule logique photosensible muni d'un transistor d'évacuation de charges ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

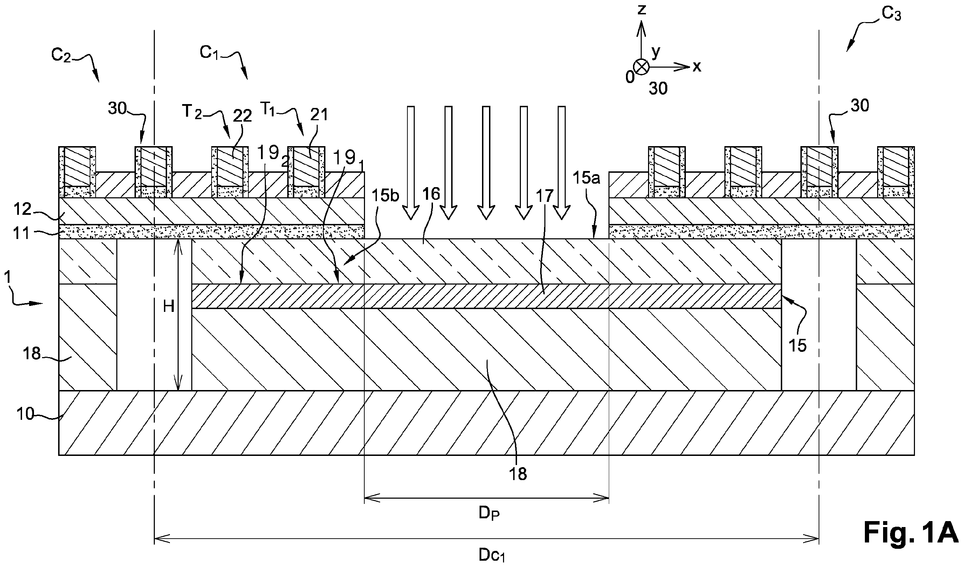

Un exemple de structure de cellule Ci photosensible et à illumination par la face avant est représenté sur la figure 1A. Cette cellule Ci peut être intégrée à un dispositif matriciel comprenant une pluralité de cellules de structures semblables $C_2$, $C_3$

La cellule $C_1$ est formé d'un premier transistor $T_1$ d'un premier type, par exemple de type P ainsi qu'un deuxième transistor $T_2$ d'un deuxième type, par exemple de type N, qui sont juxtaposés et formés sur un substrat 1 semi-conducteur sur isolant, par exemple de type SOI (SOI pour « Silicon on Insulator » ou silicium sur isolant).

Le substrat 1 comprend une couche de support 10 semi-conductrice, une couche isolante 11 reposant sur la couche de support 10, et une couche semi-conductrice 12 superficielle agencée sur la couche isolante 11 et dans laquelle le canal du premier transistor $T_1$ et du deuxième transistor $T_2$ sont prévus. Les transistors $T_1$ et $T_2$ peuvent être des transistors MOS (MOS pour « Metal Oxide Semi-conductor ») réalisés par exemple selon une technologie de type SOI totalement désertée à oxyde enterré mince, appelée UTBB-FDSOI (pour « Ultra-Thin Body and Box » - « Fully Depleted Silicon On Insulator »). Le premier transistor $T_1$ et le deuxième transistor $T_2$ comportent respectivement un premier bloc 21 de grille et un deuxième bloc de grille 22, les régions de source et de drain des transistors $T_1$, $T_2$ pouvant s'étendre dans des régions semi-conductrices formées de part et d'autre des blocs 21, 22 sur la couche semi-conductrice superficielle 12.

La cellule Ci est dotée d'une zone photosensible 15 qui s'étend dans la couche 10. La zone photosensible 15 comporte une région 15a dite de « photo-détection » ainsi qu'une autre région 15b disposée en regard du premier transistor $T_1$ et du deuxième transistor $T_2$.

Le substrat 1 est ici configuré pour permettre de favoriser la collecte de photons par sa face avant. Par « face avant » on entend la face sur laquelle les transistors $T_1$ et $T_2$ sont agencés. Plus spécifiquement, la couche semi-conductrice superficielle 12 est agencée de sorte qu'elle ne s'étend pas en regard de la région de photo-détection 15a.

Cette discontinuité de la couche superficielle 12 du substrat permet qu'un rayon lumineux pénétrant la région 15a de photo-détection orthogonalement par rapport à un plan principal du substrat ne traverse pas la couche superficielle 12. Par « plan principal » on entend un plan du substrat parallèle au plan [0 ; x ; y] du repère orthogonal [0 ; x ; y ; z] sur la figure 1A. La région 15a de photo-détection peut avoir une dimension critique Dp comprise par exemple entre 10 $\mu$m et 100 nm pour une cellule Ci de dimension critique Dc1 comprise par exemple entre 10.4 $\mu$m et 500 nm, typiquement de 1 $\mu$m. Par dimension critique on entend la plus petite dimension d'une zone hormis son épaisseur et mesurée parallèlement au plan [0 ; x ; y].

La cellule Ci est configurée de sorte qu'une tension photo-générée du côté de la zone photosensible 15 est apte à induire une tension correspondante par couplage électrostatique du côté de la couche semi-conductrice superficielle 12.

Pour cela, la zone photosensible 15 et la zone de canal du premier transistor $T_1$ sont séparées par l'intermédiaire de la couche isolante 11, dont la configuration, en particulier sa composition et son épaisseur $e_2$, sont prévues de manière à permettre l'établissement du couplage électrostatique entre une région 15b de la zone photosensible 15 et les zones de canal respectives des transistors $T_1$, $T_2$. Pour permettre le couplage électrostatique entre la couche de support 10 et la couche semi-conductrice superficielle 12, on prévoit de préférence une couche isolante 11 de faible épaisseur. La couche isolante 11 peut être par exemple à base de $SiO_2$ et avoir une épaisseur $e_2$ qui peut être comprise par exemple entre 5 nm et 50 nm, de préférence entre 10 et 25 nm.

Dans l'exemple particulier de la figure 1A, la zone photosensible 15 est formée d'un empilement entre une zone dopée 18 selon un dopage de type P et une zone dopée 16 selon un dopage de type N. Ainsi, une première jonction $19_1$ de type NP est disposée en regard du premier transistor $T_1$, tandis qu'une deuxième jonction $19_2$ de type NP en regard du deuxième transistor $T_2$. Les jonctions $19_1$, $19_2$ sont dans cet exemple réalisées dans une couche de substrat globalement dopée P. La zone de charge d'espace 19 (ZCE) entre la zone 16 dopée N et la zone 18 dopée P est également représentée sur la figure 1A. Typiquement, la hauteur H (dimension mesurée parallèlement à l'axe z du repère orthogonal [0; x ; y; z] donné sur la figure 1A) de la zone photosensible 15 peut être comprise par exemple entre 100 nm et 5 $\mu$m.

Dans cet exemple de configuration avec une zone supérieure 16 dopée N et une zone inférieure 18 dopée P, la couche de support 10 peut être dopée P pour mettre une isolation électrique entre les cellules.

Afin d'isoler électriquement la cellule Ci et un élément extérieur à cette cellule Ci également réalisé sur le substrat, par exemple une autre cellule photosensible $C_2$, $C_3$ on prévoit une électrode de grille 30 de transistor. Cette électrode de grille 30 est formée en périphérie de la cellule Ci et est configurée pour, lorsqu'elle est polarisée de manière adéquate, permettre d'isoler électriquement la cellule Ci de sa cellule voisine $C_2$ ou $C_3$.

Ainsi, on réalise ici une isolation entre cellules voisines sans mettre en oeuvre une structure de tranchée isolante, en particulier de type STI (pour « Shallow Trench Isolation »). Ceci permet de réaliser un gain de place qui peut se traduire par la possibilité de réaliser une zone de photo-détection de taille plus étendue, ce qui conduit au final à améliorer la sensibilité de la cellule Ci.

La gravure des tranchées pour former des structures STI peut engendrer la création de défauts. Aussi, la mise en oeuvre d'une isolation au moyen de l'électrode grille 30 permet également de réduire les courant de fuites et d'augmenter la rapidité de fonctionnement de la cellule Ci.

L'électrode de grille 30 est formée en regard d'une région de la couche de support qui est disposée en périphérie de la zone photosensible 15 et ne comporte pas de jonction ou de région photosensible. Dans cet exemple, la région de la couche de support 10 en regard de laquelle l'électrode de grille 30 se situe est une région dopée P.

Un transistor doté de la grille 30 est polarisé de sorte à bloquer le passage de courant autour de la cellule Ci. Le potentiel de polarisation appliqué sur la grille 30 dépend du type de transistor N ou P qui lui est juxtaposé. Dans l'exemple de réalisation particulier de la figure 1A, le transistor supplémentaire est juxtaposé au transistor $T_2$ de type N et a une région de drain reliée à la région de drain du deuxième transistor $T_2$. Un potentiel de 0V peut être par exemple appliqué sur la grille 30 supplémentaire pour permettre de placer le transistor supplémentaire à l'état bloqué afin qu'il remplisse sa fonction d'isolation électrique. Dans un autre cas (non représenté), par exemple où le transistor supplémentaire est juxtaposé au transistor $T_2$ de type P, un potentiel Vdd peut être appliqué sur la grille 30 pour permettre d'isoler la cellule Ci de sa ou ses cellule(s) voisine(s).

La grille 30 d'isolation peut avoir une largeur (dimension mesurée parallèlement au vecteur x sur la figure 1A) comprise par exemple entre 30 nm et 100 nm, tandis que la largeur des grilles 22, 21 des transistors $T_2$, $T_1$, peut-être par exemple comprise entre 20 nm et 60 nm. Cette dimension dépend du noeud technologique utilisé.

Avantageusement, on forme l'électrode de grille 30 dans un même matériau ou une même couche ou un même empilement que les électrodes de grilles 21, 22 respectives du premier transistor $T_1$, et du deuxième transistor $T_2$.

La cellule Ci photosensible de la figure 1A peut être configurée de manière à former un inverseur logique photosensible, en particulier de type CMOS.

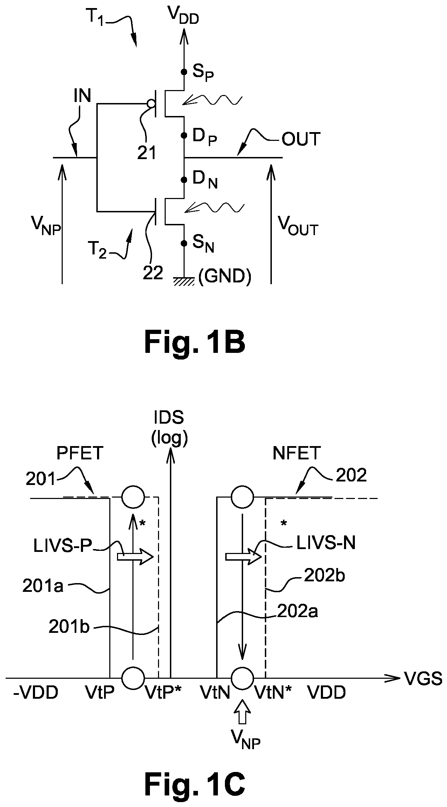

Un premier exemple d'inverseur logique photosensible CMOS formé à partir de la cellule de la figure 1A, est donné sur la figure 1B.

L'état logique d'un signal $V_{OUT}$ émis en sortie OUT de cet inverseur dépend de la quantité de photons reçue par la zone photosensible 15 en regard du premier transistor $T_1$ et du deuxième transistor $T_2$.

L'inverseur logique comporte une borne IN reliée aux grilles 21 et 22 respectives du premier transistor $T_1$ et du deuxième transistor $T_2$, tandis que les grilles 21 et 22 sont connectées entre elles.

Un circuit de polarisation est prévu pour appliquer à une borne IN de l'inverseur un potentiel de polarisation $V_{IN} = V_{NP}$ adapté, qui, dans cet exemple de configuration, est un potentiel fixe et choisi dans une gamme de tension prédéterminée.

Une sortie OUT de l'inverseur, permettant de délivrer le signal logique ou binaire $V_{OUT}$, est reliée aux drains $D_P$ et $D_N$ respectifs du premier transistor $T_1$ et du deuxième transistor $T_2$, les drains $D_P$ et $D_N$ étant connectés entre eux.

Le dispositif comprend également un moyen de polarisation de la source du premier transistor $T_1$ prévu pour appliquer un potentiel $V_{DD}$ à la source $S_P$. La source $S_N$ du deuxième transistor $T_2$ peut être placée à un potentiel Vss de référence ou GND servant de masse.

Ainsi, les transistors $T_1$ et $T_2$ sont dans cet exemple polarisés de manière à avoir une tension grille-source $V_{GS}$ constante, le changement d'état de conduction passant ou bloqué des transistors étant obtenu par décalage de leurs tensions de seuils $V_{TN}$, $V_{TP}$ respectives du fait d'une variation d'éclairement de la zone photosensible.

L'amplitude du décalage de tension de seuil induit par la lumière LIVS (noté $LIVS_N$ pour le transistor de type N et $LIVS_P$ pour le transistor de type P) dépend pour chaque transistor d'un rapport que l'on appelle « Body Factor » de capacité entre son canal et une région de la zone photosensible jouant le rôle d'une grille arrière, le Body Factor (BF) dépend du potentiel de polarisation appliqué à la zone dopée inférieure 18.

Le signe de la tension Vpol1, Vpol2 appliquée pour contrôler le décalage de tension de seuil LIVS dépend du sens de la jonction (P/N ou N/P), sous la couche isolante de BOX sur laquelle les canaux des transistors repose.

Sur la figure 1C, des courbes 201, 202 de variations respectives des courants drain-source du premier transistor $T_1$ et du deuxième transistor $T_2$ en fonction de leurs tensions grille-source respectives sont données. Cette figure montre des décalages de tensions de seuil $LIVS_P$ du premier transistor $T_1$ et $LIVS_N$ du deuxième transistor $T_2$ engendrés par la réception d'une quantité de photons donnée ou par une augmentation donnée d'une quantité de photons reçus par la zone photosensible 15 disposée en regard des transistors $T_1$, $T_2$.

La tension de seuil du premier transistor $T_1$ est susceptible de passer d'une valeur Vtp lorsque la zone photo-sensible n'est pas éclairée ou insuffisamment éclairée (portion 201a de la courbe 201 en trait continu) à une valeur Vtp* lorsque la zone photosensible est éclairée ou suffisamment éclairée (portion 201b de la courbe 201 en trait discontinu), avec |Vtp * -Vtp| qui peut être par exemple de l'ordre de 100 mV. A quantité de photons reçue par la zone photosensible égale, cette différence de tension de seuil |Vtp * -Vtp| peut être augmentée en diminuant l'épaisseur de la couche isolante 11 du substrat plus faible, et/ou en augmentant l'épaisseur choisie de la couche semi-conductrice superficielle, et/ou en augmentant l'épaisseur choisie du diélectrique de grille du premier transistor $T_1$.

De même, la tension de seuil du deuxième transistor $T_2$ est susceptible de passer d'une valeur Vtn lorsque la zone photosensible n'est pas éclairée ou insuffisamment éclairée (portion 202a de la courbe 202 en trait continu) à une valeur Vtn* lorsque la zone photosensible est éclairée ou suffisamment éclairée (portion 202b de la courbe 202 en trait discontinu), avec Vtn*-Vtn qui peut être par exemple de l'ordre de 100 mV.

Dans cet exemple de configuration, l'agencement des zones dopées P et N des jonctions $19_1$, $19_2$ est tel, qu'un changement d'éclairement de la zone photosensible 15 provoque un décalage des tensions de seuil respectives Vtn et Vtp des transistors dans un même sens de variation (VtN augmentant et VtP diminuant en valeur absolue). Ainsi, une augmentation de la quantité de photons reçue par la zone photosensible 15 de l'inverseur logique est ici susceptible d'induire une diminution (en valeur absolue) de la tension de seuil du premier transistor $T_1$ (de type P) et une augmentation de la tension de seuil du deuxième transistor $T_2$ (de type N).

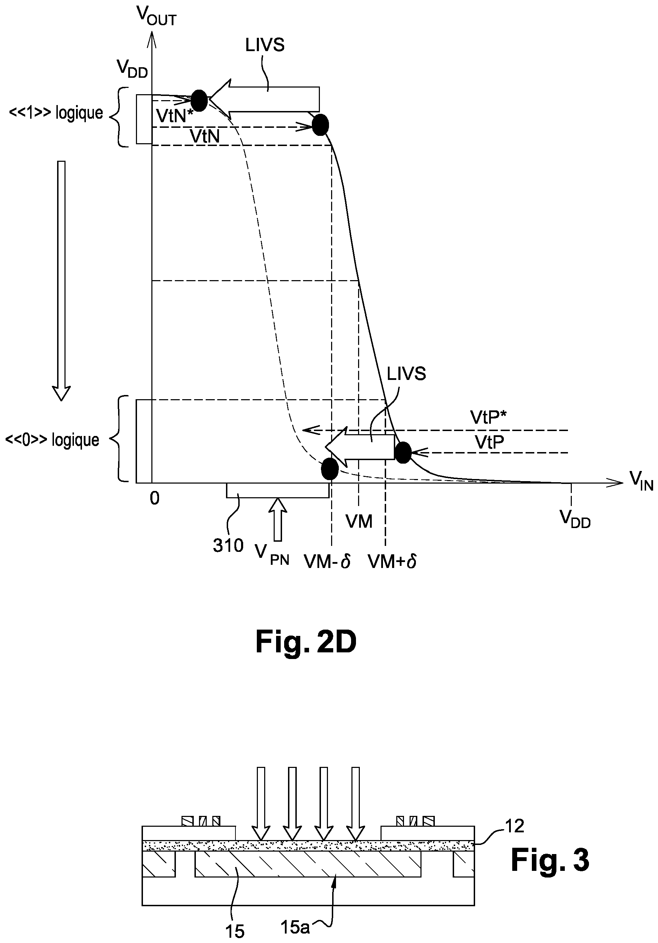

La figure 2D illustre une fonction de transfert du signal de sortie $V_{OUT}$ en fonction du signal appliqué en entrée du premier exemple d'inverseur logique lorsque celui-ci n'est pas soumis à un rayonnement lumineux (portion de courbe 211a) et lorsque celui-ci est pas soumis à un rayonnement lumineux (portion de courbe 211b).

Lorsque le potentiel $V_{NP}$ fixe de polarisation appliqué sur la borne IN est choisi dans une gamme de tension adaptée (indiquée par une portion 210 sur l'axe des abscisses) et lorsque la zone photosensible de l'inverseur passe d'un premier état d'éclairement (par exemple un état non-éclairé ou d'éclairement insuffisant) à un deuxième état d'éclairement plus important, le signal $V_{OUT}$ en sortie de l'inverseur est susceptible de passer d'un niveau $V_{OUT} = 0V$ représentatif par exemple d'un 0 logique en sortie de l'inverseur à un niveau $V_{OUT} = V_{DD}$ représentatif par exemple d'un 1 logique en sortie de l'inverseur.

Le fonctionnement est réversible de sorte que lorsque le potentiel $V_{NP}$ fixe de polarisation de la borne IN est situé dans la gamme de tension adaptée, le signal $V_{OUT}$ en sortie de l'inverseur est susceptible de passer d'un niveau $V_{OUT}=V_{DD}$ représentatif par exemple d'un 1 logique à un niveau $V_{OUT}=0V$ représentatif par exemple d'un 0 logique consécutivement à un passage de la zone photosensible de l'inverseur du deuxième état d'éclairement (éclairé ou d'éclairement suffisant) au premier état d'éclairement (non-éclairé ou d'éclairement insuffisant).

Le potentiel de polarisation $V_{NP}$ est dans cet exemple choisi de manière à être supérieur à un potentiel $V_M$ correspondant au potentiel pour lequel le potentiel $V_{OUT}$ en sortie OUT de l'inverseur est égal au potentiel $V_{IN}$ appliqué à la borne IN. Le potentiel $V_M$ est défini comme le point dans la courbe de transfert de l'inverseur pour lequel $V_{IN}=V_{OUT}$ (et qui correspond à une intersection entre la courbe de transfert 211 avec une bissectrice B d'un angle formé par les axes d'un repère sur lequel la courbe 211 est représentée).

Le potentiel de polarisation $V_{NP}$ est choisi de préférence tel que $V_{NP}$ est supérieur à $V_M + \delta$ avec $\delta$ une tension dépendante de la marge au bruit et qui est fonction de la tension $V_{DD}$.

On choisit avantageusement le potentiel de polarisation $V_{IN}=V_{NP}$ appliqué à la borne IN tel que :

$$V_M + \delta < V_{NP} < V_M + \delta + \frac{LIVS_N + |LIVS_P|}{2}$$

Or,

$$V_M = \frac{V_{DD} - |Vt_P| + Vt_N \sqrt{\frac{\beta_N}{\beta_P}}}{1 + \sqrt{\frac{\beta_N}{\beta_P}}}$$

avec :

$$\beta_N = \mu_N * Cox_N * \left(\frac{W}{L}\right)_N$$

$$\beta_P = \mu_P * Cox_P * \left(\frac{W}{L}\right)_P$$

Alors qu'un inverseur classique bascule à une tension $V_M$, on peut considérer dans le cas présent que :

- le niveau de sortie logique est à un niveau logique 1 lorsque VIN < VM -$\delta$,
- le niveau de sortie logique est à un niveau logique 0 lorsque VIN > VM + $\delta$,

Nous définissions :

$$|Vt_P^*| = |Vt_P| + LIVS_P$$

avec :

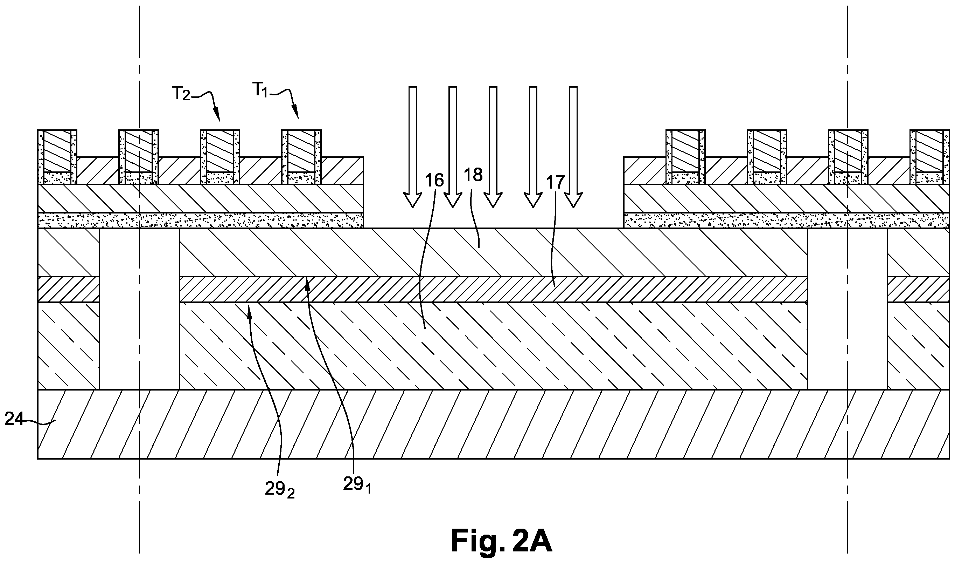

LIVS$_P$ <0 pour un agencement BOX/N/P des zones dopées N et P des jonctions c'est à dire telle que sur la figure 2A et

$$Vt_N^* = Vt_N + LIVS_N$$

avec :

LIVS$_N$ >0 pour un agencement BOX/N/P des zones dopées N et P de la deuxième jonction tel que sur la figure 1A.

Le potentiel $V_{NP}$ de polarisation de l'entrée IN peut être choisi par exemple de sorte que $V_{NP}$ E [VM ; VM + 200 mV] $V_M$ dépendant de Vt$_N$, Vtp, et de $V_{DD}$.

Si on applique à l'inverseur logique photosensible un premier niveau d'éclairement, le transistor $T_2$ de type N est passant et le transistor $T_1$ de type P est bloqué.

On place ainsi la sortie au potentiel Vss ou de masse, c'est-à-dire à l'état bas. Inversement, quand on applique à l'inverseur logique photosensible un deuxième niveau d'éclairement, le transistor $T_1$ de type P est passant et le transistor $T_2$ de type N est bloqué. La sortie se trouve donc au potentiel $V_{DD}$ qui traduit un état haut. On a donc réalisé une fonction inversion ou un NON logique.

L'inverseur logique photonique dont la sortie dépend de l'éclairement qu'il reçoit et peut ainsi suivre la table de vérité suivante :

| IN | Lumière | OUT |
|----|---------|-----|
| $V_{NP}$ | NON | 0 |
| $V_{NP}$ | OUI | 1 |

Un deuxième exemple de configuration de cellule formant un inverseur logique photosensible est donné sur la figure 2A-2B.

Le deuxième exemple d'inverseur diffère de celui décrit précédemment notamment de par l'agencement de la zone photosensible 15 qui est pour cette variante formée d'une zone dopée 16 selon un dopage de type N sur laquelle une zone dopée 18 selon un dopage de type P est disposée. La zone 18 dopée P est dans cet exemple située sous la couche isolante 12 de BOX et agencée entre la zone 16 dopée N et la couche superficielle 12. Ainsi, une première jonction $29_1$ de type PN est placée en regard du premier transistor $T_1$, tandis qu'une deuxième jonction $29_2$ de type PN est située en regard du deuxième transistor $T_2$.

Dans l'exemple particulier de la figure 2A, une zone dopée 24 supplémentaire N+ est prévue en contact avec la zone dopée N de la zone photosensible dans la couche de support 10 afin de permettre de polariser les jonctions.

En variante, on peut également réaliser les jonctions $29_1$, $29_2$ dans une couche de support globalement dopée N.

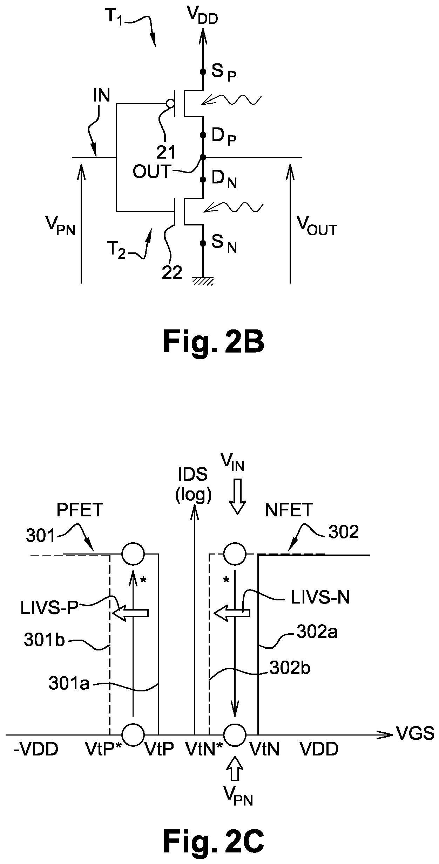

En ce qui concerne l'agencement des transistors (figure 2B) et la polarisation de leurs électrodes de source $S_P$ et $S_N$ respectives, la configuration du deuxième exemple d'inverseur est semblable à celle du premier exemple d'inverseur décrit précédemment.

La borne IN reliée aux grilles 21 et 22 respectives du premier transistor $T_1$ et du deuxième transistor $T_2$, est cette fois mise à un potentiel de polarisation $V_{PN}$ fixe adapté. Les transistors $T_1$ et $T_2$ sont ainsi polarisés de manière à avoir une tension grille-source $V_{GS}$ constante, un changement d'état passant ou bloqué respectif des transistors pouvant être obtenu en faisant varier leurs tensions de seuil $V_{TP}$ et $V_{TN}$ respectives, cette variation étant elle-même dépendante de l'état d'éclairement de la zone photosensible.

La figure 2C donne des courbes de variations 301, 302 des courants drain-source respectifs du premier transistor $T_1$ et du deuxième transistor $T_2$ en fonction de leurs tensions grille-source respectives. Elle montre des décalages LIVS$_P$ et LIVS$_N$ (illustrés respectivement par un décalage entre la portion de courbe 301a et la portion de courbe 301b pour le transistor de type P et par un décalage entre la portion de courbe 302a et la portion de courbe 302b pour le transistor de type N) des tensions de seuil respectives du premier transistor et du deuxième transistor engendrées par un éclairement ou une augmentation d'éclairement de la zone photosensible.

La tension de seuil du premier transistor $T_1$ (de type P) augmente en valeur absolue, tandis que la tension de seuil du deuxième transistor $T_2$ (de type N) diminue en valeur absolue. Le décalage de tension de seuil Vt se fait ici dans le même sens (négatif).

Dans cet exemple, pour que la sortie de l'inverseur puisse basculer d'un état logique à un autre en fonction de l'état d'éclairement de la zone photosensible, on polarise l'entrée IN de l'inverseur à un potentiel $V_{PN}$ fixe choisi dans une gamme (portion 310 sur l'axe des abscisses de la figure 2D) de tensions adaptée.

Le potentiel de polarisation $V_{PN}$ est dans cet exemple choisi de manière à être inférieur au potentiel $V_M$ et de préférence tel que $V_{PN}$ est inférieur à $V_M - \delta$ avec $\delta$ une tension dépendante de la marge au bruit.

On choisit avantageusement le potentiel de polarisation $V_{PN}$ appliqué à la borne IN tel que :

Pour un agencement BOX/P/N des zones dopées des jonctions tel qu'illustré sur la figure 2A, on définit $V_{PN}$ par :

$$V_M - \delta - \frac{LIVS_P + |LIVS_N|}{2} < V_{PN} < V_M - \delta$$

avec LIVS$_P$ > 0 et LIVS$_N$ < 0.

Lorsque le potentiel $V_{PN}$ de polarisation de l'entrée IN est choisi dans la gamme de tension adaptée et lorsque la zone photosensible de l'inverseur est dans un premier état non-éclairé ou d'éclairement insuffisant, le signal $V_{OUT}$ en sortie de l'inverseur est à un niveau $V_{OUT} = V_{DD}$ représentatif par exemple d'un '1' logique en sortie de l'inverseur. Lorsque le potentiel $V_{PN}$ de polarisation de l'entrée IN est choisi dans la gamme de tension adaptée et lorsque la zone photosensible de l'inverseur est dans un deuxième état éclairé ou d'éclairement suffisant, le signal $V_{OUT}$ en sortie de l'inverseur est à un niveau $V_{OUT} = 0V$ représentatif par exemple d'un '0' logique en sortie de l'inverseur.

Le deuxième exemple d'inverseur logique photonique peut ainsi suivre la table de vérité suivante :

| IN | Lumière | OUT |
|---|---|---|
| $V_{PN}$ | NON | 1 |
| $V_{PN}$ | OUI | 0 |

A l'aide de cellules photosensibles telles que décrites précédemment, on peut mettre en oeuvre un circuit logique apte à être commandé par la lumière et dont les fonctions, en particulier logiques, sont modifiables en fonction du niveau d'éclairement que ce circuit logique reçoit.

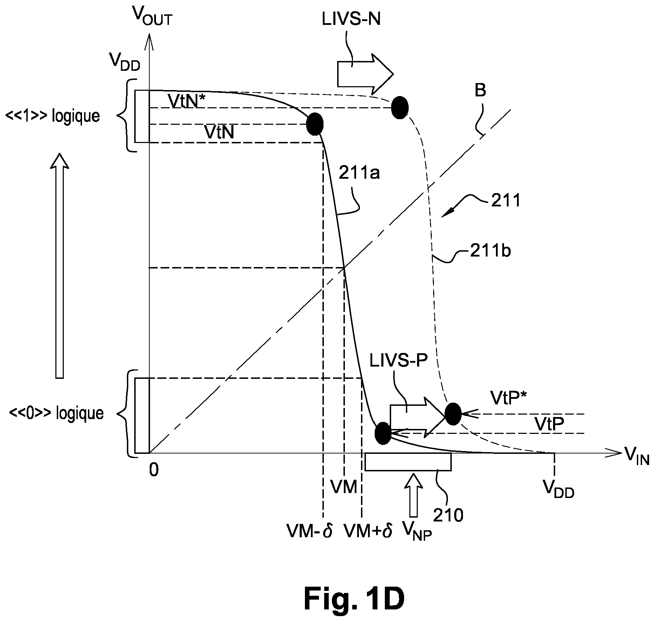

Les figures 1D et 2D montrent que, dans une certaine gamme de tension appliquée à l'entrée IN d'un inverseur logique photosensible on peut faire basculer, par une variation d'éclairement et un apport suffisant de photons, la sortie logique OUT de l'inverseur, l'état logique de cette sortie OUT ne basculant pas lorsque l'apport de photons est insuffisant. La fonction modifiable par éclairement peut être par exemple une fonction de programmation collective de cellules ou de remise à zéro. Un tel circuit logique peut être mis en oeuvre par exemple de sorte qu'une brève impulsion lumineuse ou un flash lumineux permette de faire basculer un ensemble d'inverseurs logiques photosensibles. Un circuit logique commandé, ou programmé, ou remis à zéro, sans nécessiter d'adressage spécifique, par l'intermédiaire d'un flash lumineux appliqué par exemple en face arrière d'une puce sur laquelle ce circuit est monté peut être ainsi réalisé.

Une variante d'agencement de l'un ou l'autre des exemples de cellules logiques photosensibles décrites précédemment est une configuration selon l'invention illustrée sur la figure 3.

La couche isolante 11 du substrat semi-conducteur sur isolant est cette fois conservée en regard de la région 15a de photo-détection.

Avec une telle configuration, on limite les phénomènes de recombinaisons de surface. La couche isolante 11 peut également jouer le rôle de couche antireflet. Comme dans les exemples précédemment décrits, la région 15a de photo-détection n'est pas recouverte par la couche superficielle 12 du substrat.

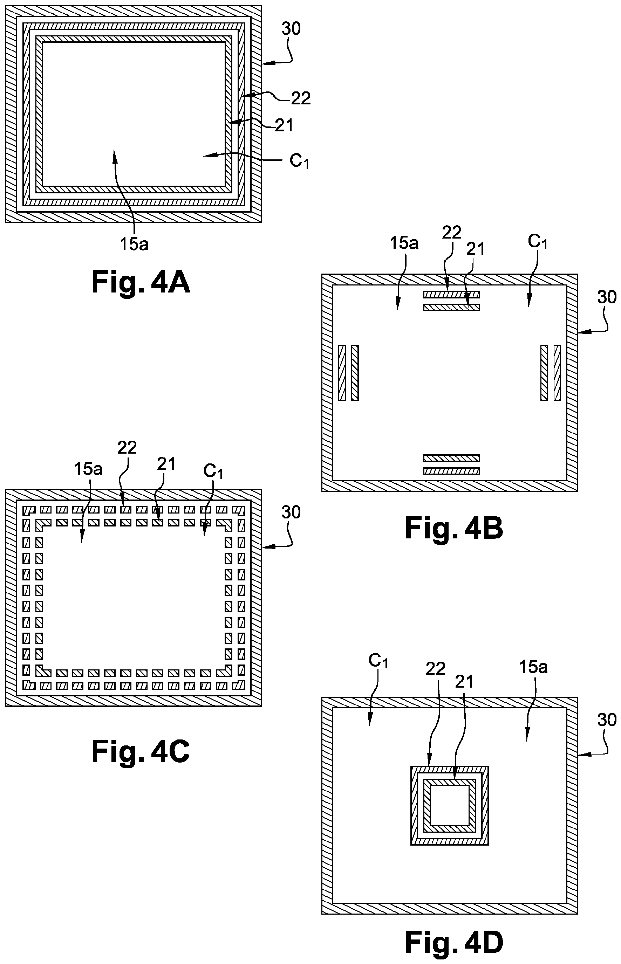

Sur les figures 4A-4D différents exemples d'agencements des électrodes de grilles des transistors $T_1$, $T_2$ d'une cellule logique photosensible telle que décrite précédemment sont donnés.

Pour tous ces exemples, la cellule Ci est délimitée en périphérie par la grille 30 qui sert à isoler électriquement la cellule Ci. La grille supplémentaire 30 réalise un contour fermé continu autour des transistors $T_1$, $T_2$ et de la région de photo-détection 15a.

Dans les exemples des figures 4A-4C, les grilles 21, 22 des transistors $T_1$, $T_2$ sont entourées par la grille supplémentaire 30 et sont également disposées en périphérie de la cellule Ci et autour de la région 15a de photo-détection.

Le choix entre ces configurations sera porté par le compromis consommation statique/sensibilité.

L'exemple d'agencement de la figure 4A permet d'obtenir une sensibilité améliorée par rapport à celui de la figure 4C, mais la configuration de la figure 4C est plus avantageuse en termes de consommation.

En variante, on peut, comme sur l'exemple de réalisation de la figure 4D, disposer les grilles 21, 22 des transistors $T_1$, $T_2$ au centre de la cellule Ci pour diminuer davantage la consommation. Dans ce cas, la région 15a de photo-détection est située autour des grilles 21, 22 des transistors $T_1$, $T_2$ entre ces grilles 21, 22 et l'électrode supplémentaire 30.

Les grilles 21, 22 peuvent réaliser un contour fermé continu comme sur la figure 4A ou sous forme de blocs discontinus comme dans les exemples de réalisation des figures 4B-4C.

Dans l'un ou l'autre des exemples de cellules logiques photosensibles précédemment décrits, lorsque la zone photosensible 15 est illuminée, des porteurs de charges sont susceptibles de s'accumuler dans des régions situées sous la couche isolante 11 de BOX à l'interface respectivement avec les deux jonctions $29_1$, $29_2$ de type PN ou $19_1$, $19_2$ NP. Le temps de décharge de ces régions peut s'avérer insuffisamment rapide entre deux cycles de lectures de la cellule.

Une manière pour permettre de réaliser une décharge rapide de l'interface BOX/jonction, est d'intégrer dans la cellule logique photosensible un transistor dit « de décharge » dont la grille est commandée par un signal $S_{INIT}$ dont l'état change suivant l'état de fonctionnement « illumination », « lecture », ou « effacement » dans laquelle est placée la cellule.

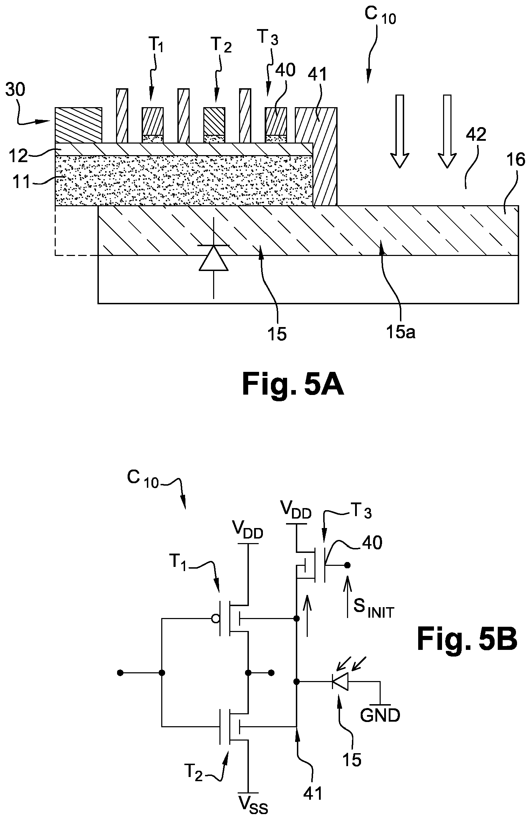

Les figures 5A-5B illustrent un exemple d'une cellule $C_{10}$ dotée d'un tel transistor de décharge $T_3$, ici de type N. La configuration de la zone photosensible 15 de la cellule $C_{10}$ peut être semblable à celle de la cellule Ci décrite précédemment en liaison avec les figures 1A, c'est-à-dire avec une zone 16 dopée N disposée sur une zone dopée P, la zone 16 dopée N étant ainsi intercalée entre la zone dopée P et la couche isolante 11 de BOX. Le transistor de décharge $T_3$ a dans cet exemple une électrode de drain connectée à la source du premier transistor $T_1$ ou mise au même potentiel que la source du premier transistor $T_1$. Le transistor de décharge $T_3$ a également une électrode de source connectée à la zone photosensible 15.

Cette connexion entre le transistor de décharge $T_3$ et la zone photosensible 15 peut être réalisée comme sur la figure 5A par le bais d'un élément conducteur 41 qui comporte une extrémité en contact avec la couche semi-conductrice 12 superficielle et une autre extrémité en contact avec la zone 16 dopée N de la région de photo-détection 15a. L'élément conducteur 41 relie en particulier la région 15a de photo-détection 15a et la couche superficielle 12 et traverse ici une ouverture 42 prévue dans la couche isolante 11 et la couche superficielle 12 du substrat en regard de la région 15a de photo-détection.

Sur la figure 5B, pour montrer l'effet de couplage électrostatique entre la zone photosensible 15 et les transistors $T_1$, $T_2$, $T_3$ ceux-ci sont représentés avec une deuxième grille, la zone photosensible 15 étant quant à elles symbolisée par une photodiode. Dans cet exemple de réalisation, la source du premier transistor $T_1$ et le drain du transistor de décharge $T_3$, peuvent être connectés ou polarisés à un même potentiel $V_{DD}$.

La source du deuxième transistor $T_2$ est mise à un potentiel Vss qui dépend de la phase de fonctionnement dans laquelle on souhaite placer la cellule, et est différent suivant que l'on effectue une lecture de l'état logique de la cellule, ou bien que la cellule se trouve en phase d'illumination ou d'effacement.

De même, la grille du transistor $T_3$ de décharge est mise au potentiel $S_{INIT}$ dont la valeur varie en fonction de la phase de fonctionnement dans laquelle la cellule est placée.

Le tableau suivant récapitule différentes état des signaux Vss et $S_{INIT}$ lors des différentes phases de fonctionnement de la cellule.

On distingue une phase d'illumination lors de laquelle la cellule $C_{10}$ est soumise à un rayonnement lumineux susceptible de modifier son état en sortie OUT, une phase de lecture de l'état de la cellule et une cellule d'effacement lors de laquelle la cellule sortie OUT de cellule peut être remise à un état initial, c'est-à-dire avant un changement d'état provoqué par un changement d'éclairement.

| Phase | Vss | $S_{INIT}$ |
|---|---|---|
| Illumination | VDD | GND |
| Lecture | GND | GND |
| Effacement | VDD | VDD |

Dans cet exemple, un effacement de la cellule et une évacuation d'électrons situés à l'interface entre la couche isolante et la couche de support, sont permis en modifiant le potentiel de grille du transistor de décharge.

Ainsi, lorsque la cellule est dans une phase de lecture ou d'illumination la grille du transistor est mise à un premier potentiel $S_{INIT}$ =GND de sorte à bloquer le transistor de décharge, puis lorsqu'on souhaite effacer l'état logique en sortie de la cellule la grille du transistor de décharge $T_3$ est mise à un deuxième potentiel $S_{INIT}$=VDD de sorte à rendre le transistor de décharge passant.

Ainsi, lorsque la cellule est dans une phase de lecture ou d'illumination la grille du transistor est mise à un premier potentiel $S_{INIT}$ =GND de sorte à bloquer le transistor de décharge $T_3$, puis lorsqu'on souhaite effacer l'état logique en sortie de la cellule la grille du transistor de décharge $T_3$ est mise à un deuxième potentiel $S_{INIT}$=VDD de sorte à rendre le transistor de décharge passant.

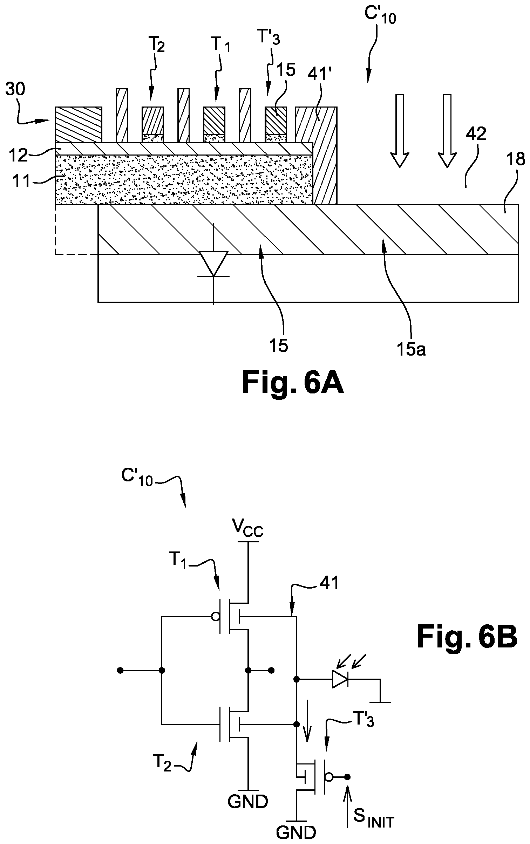

Une variante de réalisation est illustrée sur les figures 6A-6B avec une cellule $C'_{10}$ cette fois dotée d'un transistor de décharge $T'_3$, de type P. La zone photosensible 15 de cette cellule $C'_{10}$ peut être semblable à celle de la cellule $C'_1$ décrite précédemment en liaison avec la figure 2A, c'est-à-dire avec une zone 18 dopée P disposée sur une zone dopée N, la zone 18 dopée P étant ainsi intercalée entre la zone dopée N et la couche isolante 11 de BOX. Le transistor de décharge $T'_3$ a dans cet exemple une électrode de drain commune avec le premier transistor $T_1$ et une électrode de source connectée à la zone photo-sensible 15. Cette connexion peut être réalisée comme sur la figure 6A par le bais d'un élément conducteur 41' qui s'étend contre un bord de la couche superficielle 12 et relie cette couche à la zone 18 dopée P de la région de photo-détection 15a.

Dans cet exemple de réalisation, la source du deuxième transistor $T_2$ et le drain du transistor de décharge $T'_3$, peuvent être connectés et/ou polarisées à un même potentiel GND. La source du premier transistor $T_1$ est mise à un potentiel Vcc qui varie en fonction de la phase de fonctionnement dans laquelle se trouve la cellule $C'_{10}$. A la grille du transistor $T'_3$ de décharge on applique un signal $S_{INIT}$ dont la valeur varie également en fonction de la phase de fonctionnement dans laquelle se trouve la cellule.

Le tableau suivant récapitule différentes état des signaux Vcc et $S_{INIT}$ lors des différentes phases de fonctionnement de la cellule C'$_{10}$.

| Phase | Vcc | $S_{INIT}$ |
|---|---|---|
| Illumination | GND | VDD |
| Lecture | VDD | VDD |
| Effacement | GND | GND |

Un effacement de la cellule est ainsi réalisé en modifiant le potentiel de grille du transistor de décharge.

## Revendications

1. Dispositif comprenant au moins une cellule (C$_1$, C$_{10}$, C'$_{10}$) logique photosensible, la cellule comportant : un premier transistor (T$_1$) de type P et un deuxième transistor (T$_2$) de type N, le premier et le deuxième transistor reposant sur un substrat semi-conducteur sur isolant, le substrat comprenant une couche semi-conductrice superficielle (12) comportant une zone de canal du premier transistor et une zone de canal dudit deuxième transistor, une couche isolante (11) séparant la couche semi-conductrice superficielle d'une couche de support semi-conductrice (10), la couche de support (10) comprenant au moins une zone photosensible (15) configurée pour convertir des photons en porteurs de charges, la couche isolante (11) étant configurée de manière à permettre un couplage électrostatique entre la zone photosensible (15) et la fine couche semi-conductrice superficielle (12), de sorte que le premier transistor et le deuxième transistor ont respectivement une première tension de seuil (V$_{TP}$) et une deuxième tension de seuil (V$_{TN}$) modulables en fonction d'une quantité de photons reçue par la zone photosensible (15), la zone photosensible étant formée d'une zone (16) dopée N et d'une zone (18) dopée P superposées formant une première jonction (19$_1$,29$_1$) disposée en regard de la zone de canal dudit premier transistor (T$_1$) et une deuxième jonction (19$_2$,29$_2$) en regard de la zone de canal dudit deuxième transistor (T$_2$),
la première jonction (19$_1$,29$_1$) étant une jonction PN lorsque la deuxième jonction (19$_2$,29$_2$) est une jonction PN ou étant une jonction NP lorsque la deuxième jonction (19$_2$,29$_2$) est une jonction NP,
la zone photosensible (15) comprenant en outre une région de photo-détection (15a) par laquelle un flux lumineux est apte à pénétrer,
le dispositif étant caractérisé en ce que_la couche semi-conductrice superficielle (12) du substrat comprenant une ouverture de sorte que la couche semi-conductrice superficielle (12) ne s'étend pas en regard de la région (15a) de photo-détection (15a), la couche isolante (11) du substrat s'étendant en regard de la région de photo-détection (15a).

2. Dispositif selon la revendication 1, dans lequel le premier transistor et le deuxième transistor comportent respectivement une première grille (21) et une deuxième grille (22) agencées sur la couche superficielle (12), la cellule comprenant un moyen d'isolation électrique pour isoler la cellule d'au moins un autre élément du dispositif, le moyen d'isolation électrique comprenant une électrode de grille supplémentaire (30) disposée en périphérie de la cellule autour d'une région de la cellule où la première grille et la deuxième grille sont disposées.

3. Dispositif selon la revendication 2, dans lequel l'électrode de grille supplémentaire (30) forme un contour fermé autour de la première grille (21) et de la deuxième grille (22).

4. Dispositif selon l'une des revendications 2 ou 3, comprenant une autre cellule juxtaposée à ladite cellule, la couche semi-conductrice superficielle (12) étant continue et sans zone isolante entre ladite cellule et ladite autre cellule.

5. Dispositif selon l'une des revendications 1 à 4, dans lequel la première grille et la deuxième grille sont disposées en regard d'une autre région (15b) de la zone photosensible (15) située en périphérie de la région de photo-détection (15a).

6. Dispositif selon l'une des revendications 1 à 5, la cellule comprenant en outre un transistor d'évacuation (T$_3$) de charges connecté à la zone photosensible.

7. Dispositif selon la revendication 6, le transistor d'évacuation de charges et la zone photosensible étant connectés par le biais d'au moins un élément de connexion (41, 41') en contact avec la région de photo-détection (15a) et passant dans ladite ouverture.

**8.** Dispositif selon la revendication 6 ou 7, comprenant en outre un circuit de commande de polarisation configuré pour appliquer un signal ($S_{INIT}$) au transistor ($T_3$) d'évacuation de charges, ce signal ($S_{INIT}$) ayant un état variable et appliqué de sorte à bloquer le transistor ($T_3$) d'évacuation de charges lorsqu'une lecture d'un état logique en sortie de la cellule est effectué, et de sorte à rendre passant le transistor ($T_3$) d'évacuation de charges lorsqu'un effacement de l'état logique en sortie de la cellule est effectué.

**9.** Dispositif selon l'une des revendications 1 à 8, dans lequel le premier transistor et le deuxième transistor sont de type FDSOI.

**Patentansprüche**

**1.** Vorrichtung, umfassend wenigstens eine lichtempfindliche Logikzelle ($C_1$, $C_{10}$, $C'_{10}$), wobei die Zelle umfasst: einen ersten Transistor ($T_1$) vom Typ P und einen zweiten Transistor ($T_2$) vom Typ N, wobei der erste und der zweite Transistor auf einem Halbleitersubstrat auf einem Isolator ruhen, wobei das Substrat eine halbleitende Oberflächenschicht (12) umfasst, die eine Kanalzone des ersten Transistors und eine Kanalzone des zweiten Transistors umfasst, wobei eine isolierende Schicht (11) die halbleitende Oberflächenschicht von einer halbleitenden Trägerschicht (10) trennt, wobei die Trägerschicht (10) wenigstens eine lichtempfindliche Zone (15) umfasst, die dazu ausgelegt ist, Photonen in Ladungsträger umzuwandeln, wobei die isolierende Schicht (11) dazu ausgelegt ist, eine elektrostatische Kopplung zwischen der lichtempfindlichen Zone (15) und der feinen halbleitenden Oberflächenschicht (12) zu ermöglichen, derart, dass der erste Transistor und der zweite Transistor eine erste Schwellenspannung ($V_{TP}$) beziehungsweise eine zweite Schwellenspannung ($V_{TN}$) haben, die als Funktion einer Menge von Photonen modulierbar sind, die von der lichtempfindlichen Zone (15) empfangen wird, wobei die lichtempfindliche Zone mit einer N-dotierten Zone (16) und einer P-dotierten Zone (18) in Überlagerung gebildet ist, die einen ersten Übergang ($19_1$, $29_1$) bilden, welcher gegenüber der Kanalzone des ersten Transistors ($T_1$) angeordnet ist, und einen zweiten Übergang ($19_2$, $29_2$) gegenüber der Kanalzone des zweiten Transistors ($T_2$), wobei der erste Übergang ($19_1$, $29_1$) ein PN-Übergang ist, wenn der zweite Übergang ($19_2$, $29_2$) ein PN-Übergang ist, oder ein NP-Übergang ist, wenn der zweite Übergang ($19_2$, $29_2$) ein NP-Übergang ist, wobei die lichtempfindliche Zone (15) ferner eine Lichterfassungsregion (15a) umfasst, durch die ein Lichtfluss hindurch dringen kann, wobei die Vorrichtung **dadurch gekennzeichnet ist, dass** die halbleitende Oberflächenschicht (12) des Substrats eine Öffnung derart umfasst, dass sich die halbleitende Oberflächenschicht (12) nicht gegenüber der Lichterfassungsregion (15a) erstreckt, wobei sich die isolierende Schicht (11) des Substrats gegenüber der Lichterfassungsregion (15a) erstreckt.

**2.** Vorrichtung nach Anspruch 1, bei der der erste Transistor und der zweite Transistor ein erstes Gate (21) beziehungsweise ein zweites Gate (22) umfassen, die auf der Oberflächenschicht (12) angeordnet sind, wobei die Zelle ein elektrisches Isoliermittel umfasst, um die Zelle von wenigstens einem anderen Element der Vorrichtung zu isolieren, wobei das elektrische Isoliermittel eine zusätzliche Gateelektrode (30) umfasst, die an der Peripherie der Zelle um eine Region der Zelle herum angeordnet ist, wo das erste Gate und das zweite Gate angeordnet sind.

**3.** Vorrichtung nach Anspruch 2, bei der die zusätzliche Gateelektrode (30) einen geschlossenen Umfang um das erste Gate (21) und das zweite Gate (22) herum bildet.

**4.** Vorrichtung nach einem der Ansprüche 2 oder 3, umfassend eine weitere Zelle, die neben der Zelle angeordnet ist, wobei die halbleitende Oberflächenschicht (12) durchgehend und ohne isolierende Zone zwischen der Zelle und der weiteren Zelle ist.

**5.** Vorrichtung nach einem der Ansprüche 1 bis 4, bei der das erste Gate und das zweite Gate gegenüber einer anderen Region (15b) der lichtempfindlichen Zone (15) angeordnet sind, die an der Peripherie der Lichterfassungsregion (15a) angeordnet ist.

**6.** Vorrichtung nach einem der Ansprüche 1 bis 5, wobei die Zelle ferner einen Ladungsabführungstransistor ($T_3$) umfasst, der mit der lichtempfindlichen Zone verbunden ist.

7. Vorrichtung nach Anspruch 6, wobei der Ladungsabführungstransistor und die lichtempfindliche Zone mittels wenigstens eines Verbindungselements (41, 41') in Kontakt mit der Lichterfassungsregion (15a) verbunden sind und in der Öffnung verlaufen.

8. Vorrichtung nach Anspruch 6 oder 7, ferner umfassend eine Polarisationssteuerungsschaltung, die dazu ausgelegt ist, ein Signal ($S_{INIT}$) an den Ladungsabführungstransistor ($T_3$) anzulegen, wobei dieses Signal ($S_{INIT}$) einen variablen Zustand hat und derart angelegt wird, dass der Ladungsabführungstransistor ($T_3$) gesperrt wird, wenn eine Auslesung eines Logikzustands am Ausgang der Zelle durchgeführt wird, und derart, dass der Ladungsabführungstransistor ($T_3$) durchleitend gemacht wird, wenn eine Löschung des Logikzustands am Ausgang der Zelle durchgeführt wird.

9. Vorrichtung nach einem der Ansprüche 1 bis 8, bei der der erste Transistor und der zweite Transistor vom Typ FDSOI sind.

**Claims**

1. Device comprising at least one photosensitive logic cell ($C_1$, $C_{10}$, $C'_{10}$), the cell comprising: a first P type transistor ($T_1$) and a second N type transistor ($T_2$), the first and second transistor resting on a semiconductor-on-insulator substrate, with the substrate comprising a surface semiconductor layer (12) comprising a channel zone of the first transistor and a channel zone of said second transistor, with an insulating layer (11) separating the surface semiconductor layer from a semiconductor support layer (10), the support layer (10) comprising at least one photosensitive zone (15) configured to convert photons into charge carriers, with the insulating layer (11) being configured so as to allow electrostatic coupling between the photosensitive zone (15) and the thin surface semiconductor layer (12), in such a way that the first transistor and the second transistor have a first threshold voltage ($V_{TP}$) and a second threshold voltage ($V_{TN}$) respectively that can be modulated according to a quantity of photons received by the photosensitive zone (15), with the photosensitive zone being formed of a N doped zone (16) and a superimposed P doped zone (18) forming a first junction ($19_1$, $29_1$) arranged opposite the channel zone of said first transistor ($T_1$) and a second junction ($19_2$, $29_2$) opposite the channel zone of said second transistor ($T_2$), the first junction ($19_1$, $29_1$) being a PN junction when the second junction ($19_2$, $29_2$) is a PN junction, the first junction (191, 291) being a NP junction when the second junction ($19_2$, $29_2$) is a NP junction, the photosensitive zone furthermore comprising a photo-detection region through which a luminous flux can enter, the device being **characterized in that** the surface semiconductor layer of the substrate comprising an opening such that the surface semiconductor layer does not extend opposite the photo-detection region, the insulating layer (11) of the substrate extend opposite the photo-detection region.

2. Device according to claim 1 wherein the first transistor and the second transistor respectively comprise a first gate (21) and a second gate (22) arranged on the surface layer (12), the cell comprising a means of electrical insulation to insulate the cell from at least one other element of the device, the means of electrical insulation comprising an additional gate electrode (30) arranged at the periphery of the cell around a region of the cell where the first gate and the second gate are arranged.

3. Device according to claim 2, wherein the additional gate electrode (30)forms a closed outline around the first gate (21) and the second gate (22).

4. Device according to any of the claims 2 or 3, comprising another cell juxtaposed with said cell, where the surface semiconductor layer (12) is continuous and with no insulating zone between said cell and said other cell.

5. Device according to any of claims 1 to 4, wherein the first gate and the second gate are arranged opposite another region (15b) of the photosensitive zone (15) located at the periphery of the photo-detection region (15a).

6. Device according to any of the claims 1 to 5, the cell furthermore comprising a charge evacuation transistor ($T_3$) connected to the photosensitive zone.

7. Device according to claim 6, the charge evacuation transistor and the photosensitive zone being connected by means of at least one connection element (41, 41') in contact with the photo-detection region (15a) and which passes into said opening.

8. Device according to any of the claims 6 or 7, furthermore comprising a biasing control circuit configured to apply a signal ($S_{INIT}$) to the charge evacuation transistor ($T_3$), this signal ($S_{INIT}$) having a variable state and applied in such a way as to block the charge evacuation transistor ($T_3$) when a reading of a logic state at the cell output is carried out, and in such a way as to render the charge evacuation transistor ($T_3$) pass-through when an erasure of the logic state at the output of the cell is performed.

9. Device according to any of the claims 1 to 8, wherein the first transistor and the second transistor are of the FDSOI type.

Fig. 1A

**Fig. 1B**

**Fig. 1C**

**Fig. 1D**

**Fig. 2A**

**Fig. 2B**

**Fig. 2C**

**Fig. 2D**

**Fig. 3**

**Fig. 4A**

**Fig. 4B**

**Fig. 4C**

**Fig. 4D**

**Fig. 5A**

**Fig. 5B**

**Fig. 6A**

**Fig. 6B**

**EP 3 163 622 B1**

## RÉFÉRENCES CITÉES DANS LA DESCRIPTION

### Documents brevets cités dans la description

- EP 2587539 A